Europäisches Patentamt

European Patent Office

Office européen des brevets

(11) Veröffentlichungsnummer: **0 080 970**
**B1**

(12) **EUROPÄISCHE PATENTSCHRIFT**

(45) Veröffentlichungstag der Patentschrift:
**18.12.85**

(51) Int. Cl.⁴: **H 03 K 23/66**

(21) Anmeldenummer: **82710015.7**

(22) Anmeldetag: **30.03.82**

(54) **Auf nichtganze Teilungszahlen einstellbarer Frequenzteiler.**

(30) Priorität: **26.11.81 EP 81109922**
**05.03.82 DE 3207944**

(43) Veröffentlichungstag der Anmeldung:
**08.06.83 Patentblatt 83/23**

(45) Bekanntmachung des Hinweises auf die Patenterteilung:
**18.12.85 Patentblatt 85/51**

(84) Benannte Vertragsstaaten:
**DE FR GB IT NL**

(56) Entgegenhaltungen:
**EP - A - 0 044 493**
**EP - A - 0 048 821**
**DE - A - 2 639 326**
**DE - A - 2 917 017**
**DE - B - 2 753 453**

(73) Patentinhaber: **Deutsche ITT Industries GmbH,**
**Hans-Bunte-Strasse 19 Postfach 840, D-7800 Freiburg (DE)**

(84) Benannte Vertragsstaaten: **DE**

(73) Patentinhaber: **ITT INDUSTRIES INC., 320 Park Avenue, New York, NY 10022 (US)**

(84) Benannte Vertragsstaaten: **FR GB IT NL**

(72) Erfinder: **Elmis, Herbert, Ing. (grad.), Berliner Strasse 86, D-7809 Denzlingen (DE)**
Erfinder: **Backes, Reiner, Dipl.-Ing. (FH), Am Märzengraben 2, D-7800 Freiburg-Tiengen (DE)**

(74) Vertreter: **Morstadt, Volker, Dipl.-Ing., c/o Deutsche ITT Industries GmbH Patent/Lizenzabteilung Postfach 840 Hans-Bunte-Strasse 19, D-7800 Freiburg/Brsg. (DE)**

## Beschreibung

Die Erfindung betrifft einen auf nichtganze Teilungszahlen einstellbaren Frequenzteiler mit einem ganzzahlig einstellbaren Zähler, entsprechend dem Oberbegriff des Patentanspruchs 1. Ein derartiger Frequenzteiler ist aus der Offenlegungsschrift DE-A1-2 917 017 bekannt.

Bei der bekannten Anordnung sind die die ganzzahligen Stellen der Teilungszahl enthaltenden Stufen des Teilungszahlregisters direkt mit dem Einstelleingang des Zählers verbunden. Dieser Zähler wird für einen Taktimpuls über den zweiten Addierer angehalten, wenn der erste Addierer ein Überlaufsignal an den zweiten Addierer abgibt. Das Teilungszahlregisters hat ferner weitere Stufen, in denen der Dezimalbruchteil der Teilungszahl enthalten ist.

Bei der Erfindung liegen dagegen die die ganzzahligen Stellen der Teilungszahl enthaltenden Stufen des Teilungszahlregisters am zweiten Eingang des zweiten Addierers und dessen Ausgang am Einstelleingang des Zählers. Dadurch wird erreicht, dass der Zähler kontinuierlich zählt und nicht angehalten zu werden braucht.

Bei der Anordnung nach der nicht vorveröffentlichten Anmeldung EP 0 044 493 A1 wird das Problem der nichtganzzahligen Frequenzteilung innerhalb einer Frequenzsyntheseanordnung dadurch zu lösen versucht, dass der das frequenzzuteilende Signal erzeugende Generator zwischen zwei Frequenzen umschaltbar ist, deren eine um etwa 1 bis 10% grösser als die andere ist, und dass die Frequenzumschaltung mit gegebener Periodizität vorgenommen wird. Dies hat jeoch unter anderem den Nachteil, dass das frequenzgeteilte Ausgangssignal ein Phasenjittern aufweist.

Hier will die Erfindung Abhilfe schaffen. Es liegt der in den Ansprüchen gekennzeichneten Erfindung die Aufgabe zugrunde, einen nichtganzzahligen Frequenzteiler anzugeben, dessen Ausgangssignal kein Phasenjittern aufweist und der in der Technik integrierter Isolierschicht-Feldeffekttransistor-Schaltung, also der sogenannten MOS-Technik, flächensparend realisierbar ist.

Die Erfindung wird anhand der Figuren der Zeichnung näher erläutert:

Fig. 1 zeigt in Form eines Blockschaltbilds das der Erfindung zugrundeliegende Schaltungsprinzip,

Fig. 2 zeigt den zeitlichen Zusammenhang zwischen dem frequenzzuteilenden und dem frequenzgeteilten Signal,

Fig. 3 zeigt das logische Schaltbild eines älteren Ripple-Carry-Addierers, wobei von den n Stufen die Stufe 0, die die Stellensignale mit der niedersten Wertigkeit $2^0$ verarbeitet, sowie die aufeinanderfolgenden Stufen i, j gezeigt sind, [vergleiche EP-A-O-048 821, die zum Stand der Technik im Sinne von Art. 54(3) EPÜ gehört],

Fig. 4 zeigt das transistorisierte Schaltbild einer Stufe der Anordnung nach Fig. 3,

Fig. 5 zeigt das transistorisierte Schaltbild der niedersten Stufe 0,

Fig. 6 zeigt die Zellen 1. und 2. Art nach einer Ausführungsform der Erfindung,

Fig. 7 zeigt die Stufen 1. und 2. Art nach der obigen Ausführungsform der Erfindung, und

Fig. 8 zeigt die Zusammenschaltung der Zellen und Stufen.

Für die Beschreibung ist vorausgesetzt, dass die Binärsignale in positiver Logik verarbeitet werden. Ferner ist die Darstellung in den Figuren mittels der Schaltsymbole der Verknüpfungsglieder so gewählt, dass nur solche Verknüpfungsglieder einen eigenen Arbeitswiderstand aufweisen, deren Ausgangsleitung am Berührungspunkt mit dem Halbkreis des Verknüpfungssymbols den zur Darstellung einer Invertierung üblichen Punkt aufweisen. Aus diesem Grund wird für die Zwecke der vorliegenden Beschreibung auch zwischen einem Verknüpfungsglied, das eine derartige Schaltung mit einem einzigen Arbeitswiderstand ist, und einer Verknüpfung als solcher unterschieden, die lediglich Teil eines Verknüpfungsglieds oder -Gatters ist und keinen gesonderten Arbeitswiderstand aufweist.

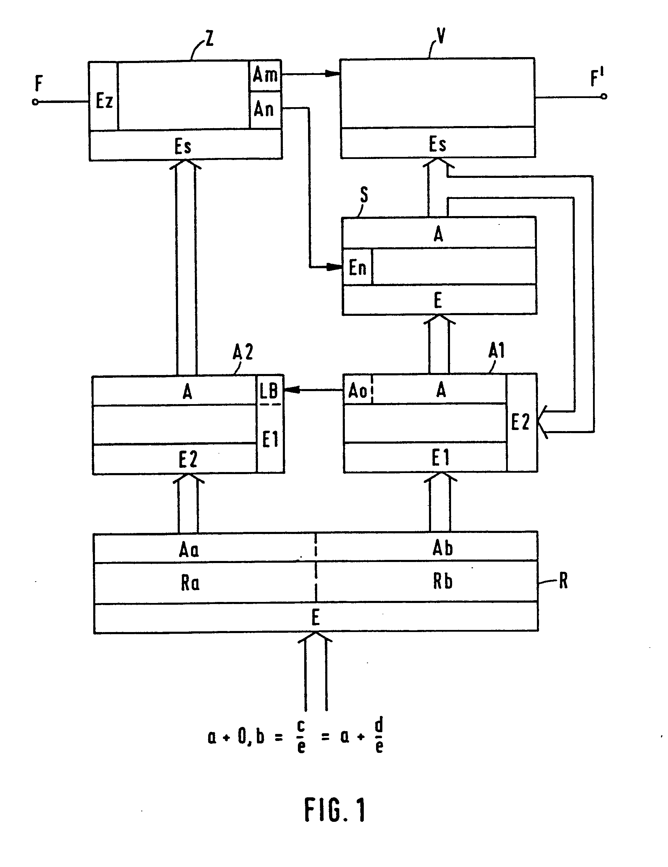

Im Prinzipschaltbild der Fig. 1 ist der über seine Einstelleingänge Es ganzzahlig einstellbare Zähler Z gezeigt, dessen Zähleingang Ez das frequenzzuteilende Signal F zuzuführen ist. Sein Höchstzählerstandsausgang Am ist mit dem Eingang der digital einstellbaren Verzögerungsleitung V verbunden, an deren Ausgang das nichtganzzahlig frequenzgeteilte Signal F' abzunehmen ist. Die Einstellschrittweite der Verzögerungsleitung V ist so zu wählen, dass sie gleich der durch den Nenner e der Teilungszahl c/e geteilten Periodendauer T des frequenzzuteilenden Signals F ist. Für die Zwecke der Erfindung wird auf die verschiedenen, mathematisch möglichen Schreibweisen einer nichtganzen Zahl zurückgegriffen, die in allgemeiner Form wie folgt geschrieben werden kann:

$$a + 0,b = \frac{c}{e} = a + \frac{d}{e}$$

In dieser Beziehung entspricht der linke Term der bekannten Kommaschreibweise (z.B. 1,2), der mittlere Term der Schreibweise als unechter Bruch (z.B. 6/5) und der rechte Term der aus ganzer Zahl und echtem Bruch bestehenden Mischschreibweise (1 1/5).

Die Einstellschrittweite der Verzögerungsleitung V muss also gleich dem e-ten Teil der Periodendauer T sein. Als digital einstellbare Verzögerungsleitung V kann die Anordnung nach der eigenen älteren europäischen Anmeldung 8 120 255.8 vorteilhaft benutzt werden. Diese besteht im wesentlichen aus der signalflussmässigen Reihenschaltung von mittels Isolierschicht-Feldeffekttransistoren integrierten Inverterpaaren, deren inhärente Paar-Verzögerungszeit durch variablen Abgriff an verschiedenen Ausgängen der Reihenschaltung ausgenützt und aufsummiert ist. Durch periodisches In-Ring-Schalten einer ungeraden Anzahl von Invertern kann bei der Anordnung des älteren Vorschlags aus der dann einsetzenden Eigenschwingung die Paar-Verzögerungszeit ermittelt werden und mittels einer aus dieser Messung abgeleiteten Regelspannung, die auf die Lasttransistoren der Inverter einwirkt, die Paar-Verzögerungszeit nachgeregelt werden.

Die Teilungszahl wird in Kommaschreibweise, also entsprechend der oben angegebenen Definition in der Form a + 0, b, an den Eingang E des Teilungszahlregisters R angelegt und in dieses somit eingeschrieben. Es besteht aus den die nichtganzen Stellen b enthaltenden Stufen Rb und den die ganzen Stellen a enthaltenden Stufen Ra mit den entsprechend zugeordneten Ausgängen Ab bzw. Aa. Der Ausgang Ab der die nichtganzen Stellen der Teilungszahl enthaltenden Stufen Rb liegt am ersten Eingang E1 des ersten Addierers A1, dessen Ausgang A am Eingang E des Pufferspeichers S liegt. Sein Ausgang A ist einerseits mit den Einstelleingängen Es der Verzögerungsleitung V und andererseits mit dem zweiten Eingang E2 des ersten Addierers A1 verbunden. Der Pufferspeicher S und der erste Addierer A1 bilden somit einen sogenannten Akkumulator oder Aufsummierer für die am ersten Eingang E1 anliegenden Zahlen.

Der Überlaufausgang Ao des ersten Addierers A1 liegt an der niederstwertigen Stelle LB des ersten Eingangs E1 des zweiten Addierers A2, dessen zweiter Eingang E2 mit dem Ausgang Aa der die ganzen Stellen a der Teilungszahl enthaltenden Stufen Ra des Teilungszahlregisters R verbunden. Der Enable-Eingang En des Pufferspeichers S liegt an einem der vor dem Höchstzählerstand Am liegenden Zählerstandausgänge An des Zählers Z und wird somit pro Umlauf dieses Zählers einmal getaktet. Pro Zählerumlauf wird also im Enable-Zeitpunkt das am Ausgang A des ersten Addierers A1 stehende Wort übernommen und zugleich an den zweiten Eingang E2 des ersten Addierers A1 gelegt. Somit wird das am Eingang E1 liegende Wort mit den nichtganzen Stellen b der Teilungszahl hinzuaddiert, und am Ausgang A des Pufferspeichers S und somit am Einstelleingang Es der Verzögerungsleitung V wird pro Zählerumlauf des Zählers Z das Ergebnis um die Zahl mit den nichtganzen Stellen erhöht. Die Verzögerungszeit der Verzögerungsleitung V steigt somit pro Zählerumlauf des Zählers Z um jeweils denselben Betrag an, der der Zahl mit den nichtganzen Stellen b entspricht. Erreicht der erste Addierer A1 die durch seine Stellenzahl vorgegebene maximale Addierkapazität, so erscheint an seinem Überlaufausgang Ao ein Überlaufsignal, das der niederstwertigen Stelle LB des ersten Eingangs E1 des zweiten Addierers A2 zugeführt wird und in diesem Addierer zu einer Erhöhung des Ergebnisses um eine Einheit führt. Da der Ausgang A dieses zweiten Addierers A2 mit dem Einstelleingang Es des Zählers Z verbunden ist, wird das an sich durch die ganzen Stellen a der Teilungszahl vorgegebene Einstellwort um eine Einheit erhöht, und der Zähler Z macht einen Zählerumlauf, der eine Periode T länger ist als die übrigen Zählerumläufe. Da andererseits bei Erscheinen des erwähnten Überlaufsignals am Überlaufausgang Ao des ersten Addierers A1 dieser zugleich in seinen Zustand zurückkehrt, in dem lediglich die nichtganzen Stellen b der Teilungszahl aufsummiert sind, verschwindet das Überlaufsignal, der Zähler Z macht wieder seine kürzeren Zählerumläufe und die Verzögerungsleitung V beginnt mit der durch die nichtganzen Stellen b vorgegebenen Grundeinstellung sowie dem eventuell vorhandenen Rest der vorhergehenden Addition.

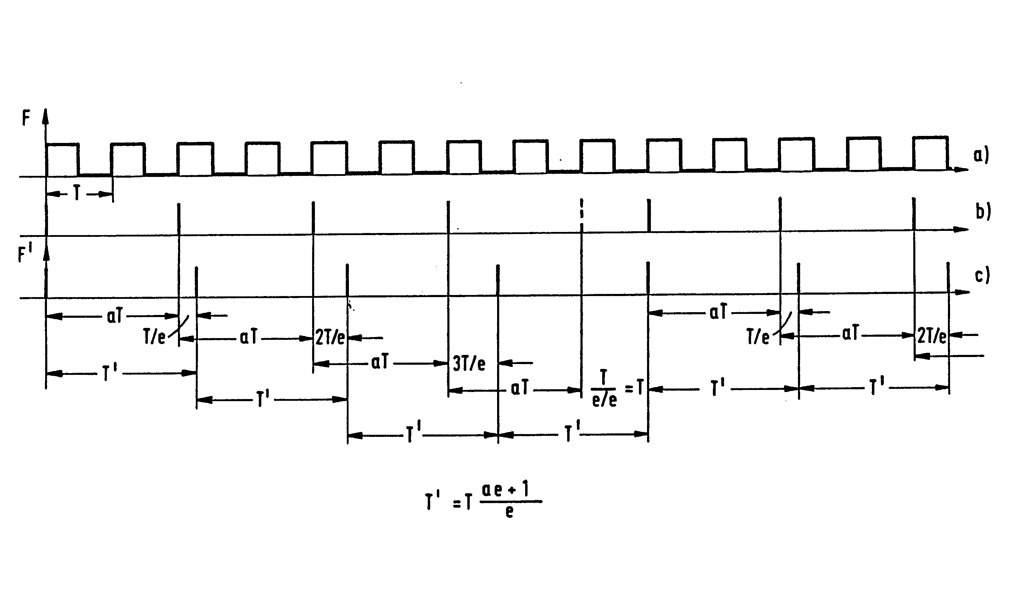

Zum besseren Verständnis der eben geschilderten Funktionsweise ist in Fig. 2 für ein Zahlenbeispiel mit der Zahl $2,25 = 2 + 1/4$ ein Impulsdiagramm gezeigt, das in Fig. 2a den Verlauf des frequenzteilenden Signals F mit der Periodendauer T und in Fig. 2b das Eingangssignal der Verzögerungsleitung V als impulsförmige Nadeln zeigt. Beginnend mit dem mit der Ordinatenachse zusammenfallenden Impuls in Fig. 2b teilt der Zähler Z durch 2 und die Verzögerungsleitung V ist auf T/4 eingestellt, so dass nach einer Zeit 2T + T/4 der Impuls des frequenzgeteilten Signals F′ nach Fig. 2c auftritt. Beim nächsten Zählerumlauf wird im ersten Addierer A1 zu 1/4 1/4 addiert und somit die Verzögerungszeit der Verzögerungsleitung V auf T2/4 = T/2 erhöht, so dass nunmehr, ausgehend vom zweiten Impuls in Fig. 2b erst nach 2 T + T/2 der nächste Impuls des frequenzgeteilten Ausgangssignals F′ am Ausgang der Verzögerungsleitung auftritt. Beim nächsten Zählerumlauf erhöht sich das Einstellsignal für die Verzögerungsleitung auf 3/4, so dass der dritte Ausgangsimpuls des frequenzgeteilten Ausgangssignals F′ gegenüber dem dritten Impuls in Fig. 2b erst nach 2 T + 3T/4 erscheint. Beim nächsten, vierten Zählerumlauf ergibt sich am Überlaufausgang Ao des ersten Addierers A1 ein Überlaufsignal, das den Zähler auf eine um 1, also auf 3 erhöhte Teilungszahl setzt, so dass nunmehr, ausgehend vom vierten Impuls in Fig. 2b drei Taktperioden T vergehen, bis an dessen Höchstzählerstandausgang Am ein Impuls erscheint. Dieses Umschalten von der Teilungszahl 2 auf die Teilungszahl 3 ist im übrigen in Fig. 2b durch den der Teilungszahl 2 entsprechenden, jedoch nicht auftretenden gestrichelten Impuls angedeutet. Die Periodendauer T′ des Signals F′ ist immer gleich (ae + 1) T/e.

Die in Fig. 1 gezeigten bandartigen Verbindungen sollen veranschaulichen, dass es sich dabei um parallele Datenverbindungen zwischen den einzelnen Teilschaltungen handelt und dass bezüglich dieser Schaltungsteile eine parallele Signalverarbeitung erfolgt. Obwohl der Frequenzteiler nach der Erfindung für die Realisierung in beliebigen Zahlensystemen geeignet ist, wird er bei Anwendung des Binärzahlensystems besonders günstig. Dann sind nämlich die Addierer Binäraddierer und der Zähler Z ist ein Binärzähler.

Der erfindungsgemässe Frequenzteiler ist in der Technik integrierter Isolierschicht-Feldeffekttransistoren, also in der sogenannten MOS-Technik, integriert. Eine bevorzugte Anwendung besteht in einer digital arbeitenden Frequenz/Phasenregelschleife zur Synchronisierung von mit digitaler Signalaufbereitung arbeitenden Fernsehempfängern.

Das frequenzgeteilte Signal F′ weist kein Phasenjittern auf, wenn der Reziprokwert e/d des oben angegebenen echten Bruches d/e ganzzahlig ist; dann tritt nämlich nach genau e Zählerumläufen des Zählers Z das Überlaufsignal am Überlaufausgang Ao auf. Ist dagegen der Reziprokwert e/d nicht ganzzahlig, so werden beim e-ten Zählerumlauf des Zählers Z im ersten Addierer A1 die von null verschiedenen Stellen als Anfangswert für das Addieren während der nächsten e Zählerumläufe stehenbleiben, d.h.

dieser «Rest» geht nicht verloren. Somit ist das Ausgangssignal F' immer phasenjitterfrei. Der Hauptvorteil der Erfindung ergibt sich bereits durch die Lösung der Aufgabe. Bei beliebigen nichtganzen Teilungszahlen ist die maximale Phasenjitteramplitude gleich der kleinsten einstellbaren Verzögerungszeit und damit wesentlich kleiner als die Taktperiode T' des zu teilenden Signals F.

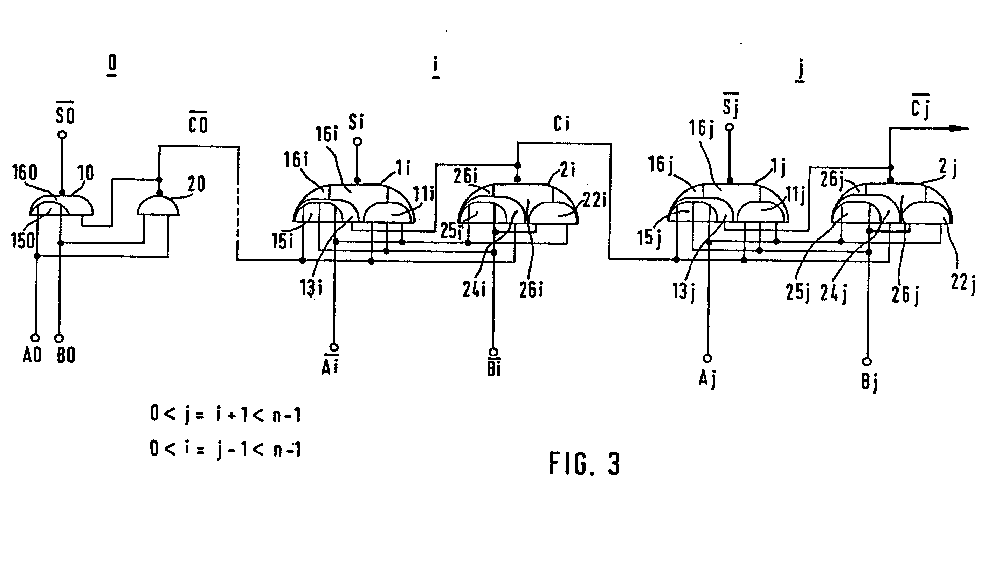

In Fig. 3 besteht die Stufe j aus dem ersten und dem zweiten Komplexgatter 1j, 2j, ebenso wie die Stufe i aus den beiden Komplexgattern 1i, 2i, während die Stufe 0 entsprechende Gatter 10, 20 aufweist, die im einzelnen unten noch näher erläutert werden.

Das erste Komplexgatter 1j besteht aus der ersten UND-Verknüpfung 11j, entsprechend das zweite Komplexgatter 2j aus der zweiten UND-Verknüpfung 22j, ferner aus der ersten ODER-Verknüpfung 15j, bzw. der zweiten ODER-Verknüpfung 25j, aus der dritten UND-Verknüpfung 13j bzw. der vierten UND-Verknüpfung 24j und aus der ersten NOR-Verknüpfung 16j, bzw. der zweiten NOR-Verknüpfung 26j. Gleiches gilt auch für den Aufbau der beiden Komplexgatter 1i, 2i in der Stufe i, wobei dann die einzelnen Verknüpfungen anstatt des Index j den Index i haben. Im ersten Komplexgatter 1j haben die erste UND-Verknüpfung 11j und die erste ODER-Verknüpfung 15j jeweils drei Eingänge, denen die beiden Stellensignale Aj, Bj und das Übertragsignal Ci der nächstniederen Stufe i zugeführt sind. Im zweiten Komplexgatter 2j haben die zweite UND-Verknüpfung 22j und die zweite ODER-Verknüpfung 25j jeweils zwei Eingänge, die mit den Stellensignalen Aj, Bj gespeist sind.

Im ersten Komplexgatter 1j hat die dritte UND-Verknüpfung 13j zwei Eingänge, deren einer mit dem Ausgang der ersten ODER-Verknüpfung 15j und deren anderer mit dem Ausgang des zweiten Komplexgatters 2j verbunden ist. Im zweiten Komplexgatter 2j hat die vierte UND-Verknüpfung 24j zwei Eingänge, deren einer mit dem Ausgang der zweiten ODER-Verknüpfung 25j verbunden ist und deren anderem das Übertragssignal Ci der nächstniederen Stufe i zugeführt ist.

Im ersten Komplexgatter 1j ist der Ausgang der ersten und der der dritten UND-Verknüpfung 11j, 13j mit jeweils einem der beiden Eingänge der ersten NOR-Verknüpfung 16j verbunden, während im zweiten Komplexgatter 2j der Ausgang der zweiten und der der vierten UND-Verknüpfung 22j, 24j jeweils an einem der beiden Eingänge der zweiten NOR-Verknüpfung 26j liegt.

In der Stufe j entsteht am Ausgang des ersten Komplexgatters 1j das invertierte Summensignal $\overline{Sj}$ und am Ausgang des zweiten Komplexgatters 2j das invertierte Übertragsignal $\overline{Cj}$. Dies ist eine Grundeigenschaft der oben genannten älteren Anmeldung, d.h. in jeder Stufe entsteht am entsprechenden Summenausgang bzw. Übertragsausgang das bezüglich der Eingangs-, also Stellensignale invertierte Signal. Aus diesem Grund ist die zur Stufe j nächstniedere Stufe i eine solche, in der an den Eingängen invertierte Stellensignale und ein invertiertes Übertragsignal anzulegen sind, so dass am Summenausgang und am Übertragsausgang das nichtinvertierte Summensignal Si und das nichtinvertierte Übertragsignal Ci entsteht. In aufeinanderfolgenden Stufen sind also Übertragausgang der vorangehenden mit dem Übertrageingang der folgenden Stufe direkt zu verbinden, während der vorangehenden Stufe die Stellensignale (oder die invertierten Stellensignale) und dann der darauf folgenden Stufe die invertierten (oder die nichtinvertierten) Stellensignale zuzuführen sind.

Die niederste Stufe 0, die die niederstwertigen Stellensignale A0 bzw. B0 zu addieren hat, braucht, da sie keinen Übertrag zu verarbeiten hat, lediglich als Halbaddierer aufgebaut zu sein. Aus diesem Grund entfällt der Übertragseingang der ersten NOR-Verknüpfung 150. Ferner besteht das erste Komplexgatter 10 nur aus der ersten NOR-Verknüpfung 150 und der NAND-Verknüpfung 160, während das zweite Komplexgatter 20 zu einem NAND-Gatter geworden ist.

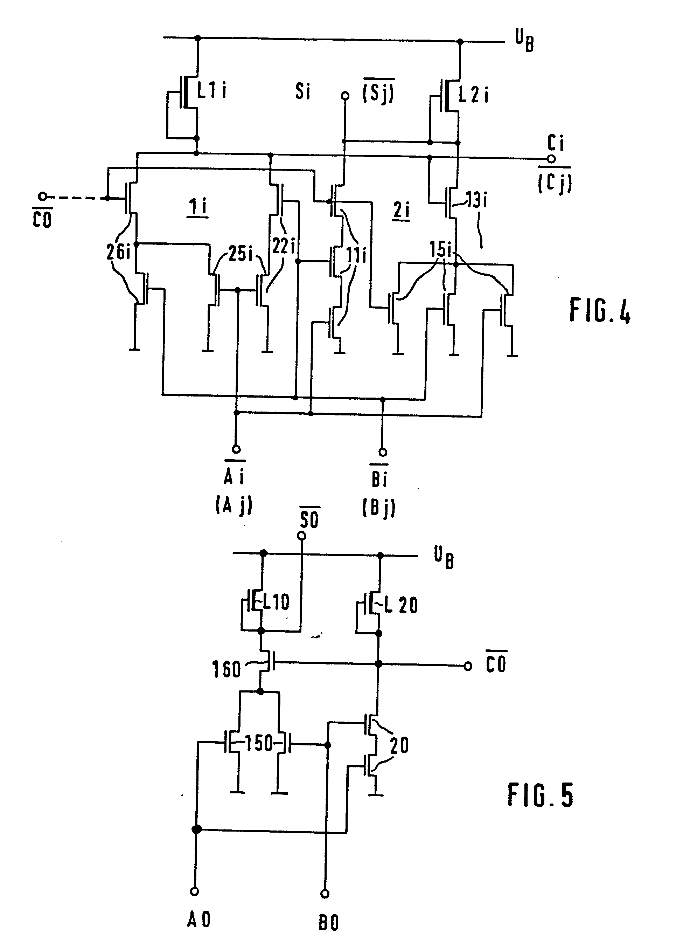

In Fig. 4 ist das transistorisierte Schaltbild einer Stufe gezeigt. Dabei realisieren mit ihren gesteuerten Strompfaden in Serie geschaltete Transistoren eine UND-Verknüpfung und mit ihren gesteuerten Strompfaden parallelgeschaltete Transistoren eine ODER-Verknüpfung. In Fig. 4 sind die einzelnen Transistoren der Einfachheit halber nicht mit unterscheidenden Bezugszeichen versehen, sondern es sind die Verknüpfungs-Bezugszeichen aus Fig. 3 mit entsprechenden Hinweislinien angegeben.

Jeder der beiden derart aufgebauten Komplexgatter arbeitet auf den entsprechenden Lastwiderstand L1i, L2i, der in der Fig. 4 als widerstandsgeschalteter Transistor vom Verarmungstyp gezeichnet ist. Diese Ausführung ist jedoch nicht zwingend, genausogut kann auch ein als Widerstand geschalteter Anreicherungstyp-Transistor eingesetzt werden, oder es können auch getaktete Lastwiderstände ggf. verwendet werden. Über die beiden Lastwiderstände L1i, L2i liegt die Stufe an der Betriebsspannung U<sub>B</sub>.

Fig. 5 zeigt das entsprechende transistorisierte Schaltbild des Halbaddierers der Stufe 0 von Fig. 3 mit den Lastwiderständen L10, L20.

Die oben genannte ältere Anordnung weist somit pro Stufe lediglich zwei jeweils auf einen Lastwiderstand arbeitende Komplexgatter auf. Für die Übertragsbildung ergibt sich somit lediglich die Laufzeit eines Gatters, so dass auch bei Parallelschaltung von vielen Stufen eine optimale Geschwindigkeit erreicht wird.

Die Anordnung der einzelnen Verknüpfungsglieder ist beim älteren Volladdierer ferner so vorgenommen, dass der Übertragsausgang einer Stufe vom Übertragseingang der nächsten Stufe kapazitiv so wenig wie möglich belastet wird, d.h. lediglich mit den Eingangskapazitäten von drei Verknüpfungsglied-Eingängen, vgl. in Fig. 4 den jeweils einen Transistor für die Verknüpfungen 26i, 11i, 15i.

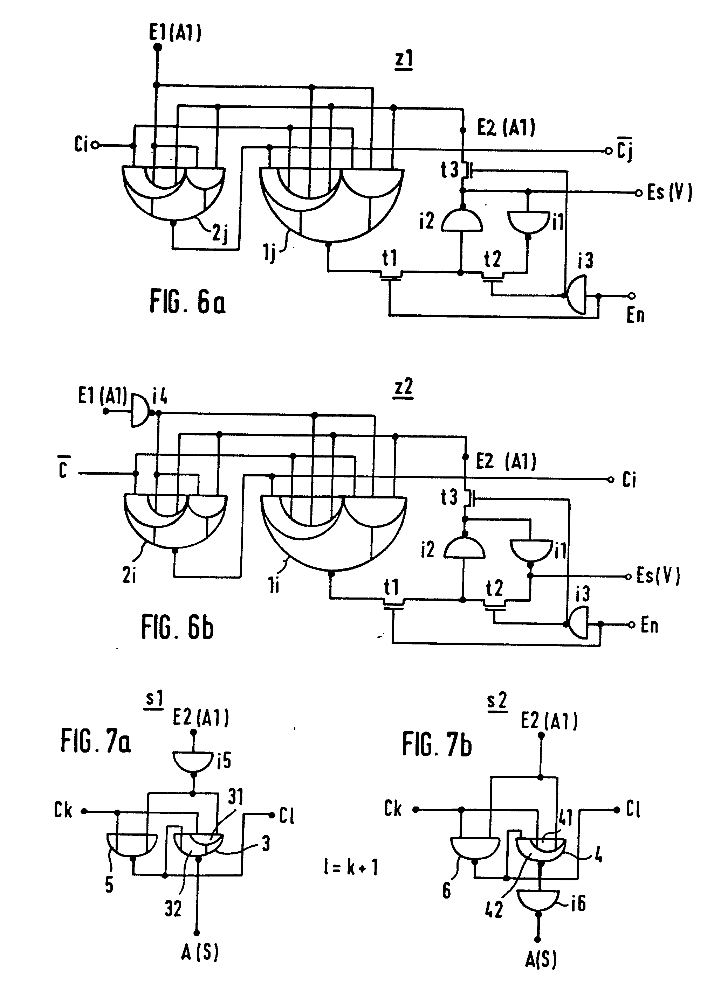

Die Fig. 6a zeigt das logische Schaltbild der Zelle z1 erster Art und Fig. 6b das der Zelle z2 zweiter Art für den ersten Addierer A1 und den Pufferspeicher S nach Fig. 1. Die Zelle z1 nach Fig. 6a besteht aus dem ersten Komplexgatter 1j, dem zweiten Komplexgatter 2j, den drei Transistoren t1, t2, t3 und den zwei Invertern i1, i2. Die Schaltstrecken des ersten und des zweiten Transistors t1, t2 liegen in Serie zwischen dem Ausgang des ersten Komplexgatters 1j und dem des ersten Inverters i1, mit dessen Eingang

der Ausgang des zweiten Inverters i2 verbunden ist. Der Eingang des zweiten Inverters i2 ist am Verbindungspunkt der Schaltstrecken des ersten und des zweiten Transistors t1, t2 und sein Ausgang über die Schaltstrecke des dritten Transistors t3 mit dem zweiten Eingang E2 der entsprechenden Stufe des ersten Addierers A1 verbunden, deren erster Eingang der erste Eingang E1 des ersten Addierers A1 ist.

Das Gate des ersten Transistors t1 ist der Enable-Eingang En der entsprechenden Stufe des Pufferspeichers S, und das Gate des zweiten Transistors t2 ist mit diesen über den allen Zellen z1, z2 gemeinsamen dritten Inverter i3 verbunden. Der Ausgang des zweiten Inverters i2 ist der Ausgang der Zelle z1 erster Art.

Die Zelle z2 zweiter Art nach Fig. 6b besteht aus denselben Teilschaltungen wie die Zelle z1 erster Art nach Fig. 6a. Diese Teilschaltungen sind auch in derselben Art und Weise untereinander verbunden, jedoch ist der Ausgang des ersten Inverters i1 der Ausgang der Zelle z2 und deren erstem Eingang ist der vierte Inverter i4 vorgeschaltet. In Fig. 6b sind das erste und das zweite Komplexgatter mit den Bezugszeichen 1i, 2i entsprechend Fig. 3 bezeichnet.

In Fig. 7a ist die Stufe s1 erster Art und in Fig. 7b die Stufe s2 zweiter Art in Form eines logischen Schaltbilds gezeigt, die abwechselnd hintereinandergeschaltet den zweiten Addierer A2 bilden. Die Stufe s1 besteht aus dem NOR-Gatter 5 mit zwei Eingängen, dem fünften Inverter i5 und dem dritten Komplexgatter 3. In der Stufe s1 nach Fig. 7a ist der Eingang des fünften Inverters i5 der zweite Eingang E2 des ersten Addierers A1. Das dritte Komplexgatter 3 enthält die UND-Verknüpfung 31 mit zwei Eingängen, deren Ausgang mit dem Übertragsausgang Cl dieser Stufe NOR-verknüpft ist. Der Übertragseingang Ck dieser Stufe liegt am ersten Eingang des NOR-Gatters 5 und am ersten Eingang der UND-Verknüpfung 31. Die erwähnte NOR-Verknüpfung trägt das Bezugszeichen 32. Der zweite Eingang der UND-Verknüpfung 31 liegt zusammen mit dem zweiten Eingang des NOR-Gatters 5 am Ausgang des fünften Inverters i5. Der Ausgang des dritten Komplexgatters 3 ist der Ausgang A und der Ausgang des NOR-Gatters 5 der Übertragausgang Cl der Stufe erster Art. s1.

Die Stufe s2 zweiter Art nach Fig. 7b besteht aus dem NAND-Gatter 6 mit zwei Eingängen, dem vierten Komplexgatter 4 und dem sechsten Inverter i6. Das vierte Komplexgatter 4 enthält die ODER-Verknüpfung 41 mit zwei Eingängen, deren Ausgang mit dem Übertragausgang Cl NAND-verknüpft ist, welche Verknüpfung in Fig. 7b das Bezugszeichen 42 trägt. Der Übertragseingang Ck liegt am ersten Eingang des NAND-Gatters 6 und am ersten Eingang der ODER-Verknüpfung 41, deren zweiter Eingang zusammen mit dem zweiten Eingang des NAND-Gatters 6 der Eingang der Stufe s2 zweiter Art ist. Der Ausgang des NAND-Gatters 6 ist der Übertragsausgang Cl und der Ausgang des sechsten Inverters i6 der Ausgang A der Stufe s2 zweiter Art.

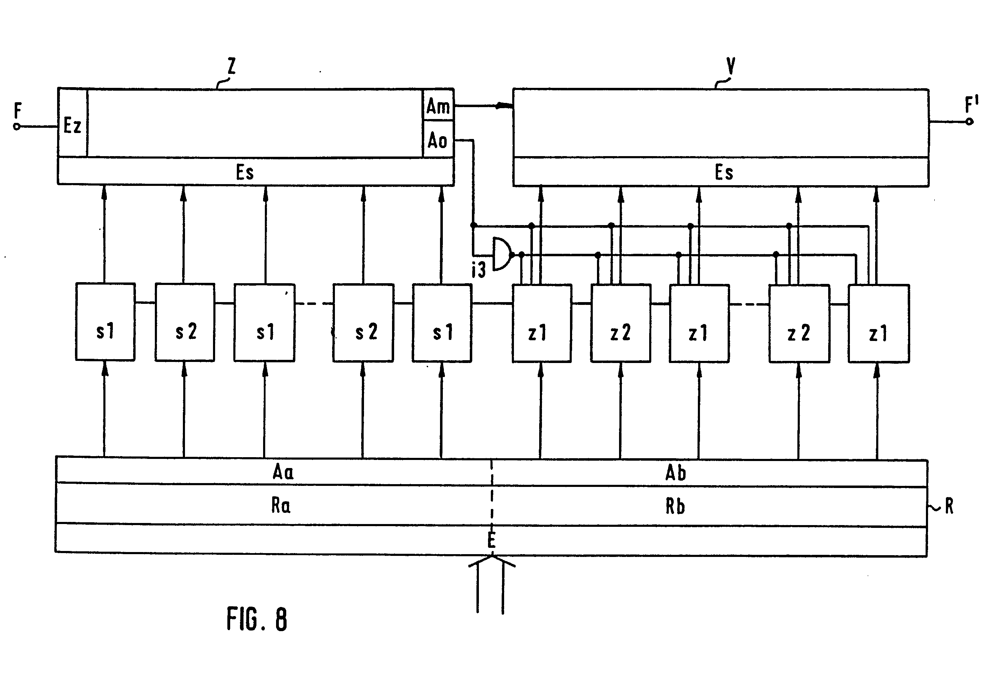

In Fig. 8 ist schematisch die Zusammenschaltung der Zellen z1, z2 erster und zweiter Art sowie der Stufen s1, s2 erster uns zweiter Art mit dem Zähler Z, der Verzögerungsleitung V und dem Teilungszahlregister R gezeigt. Die waagrechte Verbindungslinie der Zellen z1, z2 und Stufen s1, s2 ist die Verbindung von Übertragseingang und Übertragsausgang wie sie bei Ripple-Carry-Addierern üblich ist.

Der Vorteil der Ausführungsformen nach den Fig. 6 bis 8 besteht unter anderem darin, dass für den ersten Addierer A1 und den Pufferspeicher S zellenweise eine weitgehend identische Schaltung in MOS-Technik vorliegt, und dass für den zweiten Addierer A2 eine vereinfachte MOS-Schaltung angegeben ist, die berücksichtigt, dass lediglich in der niederstwertigen Stelle addiert werden muss.

## Patentansprüche

1. Auf nichtganze Teilungszahlen (c/e) einstellbarer Frequenzteiler mit einem ganzzahlig einstellbaren Zähler (Z), wobei
- die die nichtganzen Stellen (b) der Teilungszahl (c/e) in Kommaschreibweise (a + 0,b) enthaltenden Stufen (Rb) eines Teilungszahlregisters (R) mit dem ersten Eingang (E1) eines ersten Addierers (a1) verbunden sind, dessen Ausgang (A) am Eingang eines Pufferspeichers (S) liegt,
- der Ausgang des Pufferspeichers (S) einerseits am zweiten Eingang (E2) des ersten Addierers (A1) und andererseits am Einstelleingang (Es) einer digital einstellbaren Verzögerungsleitung (V) liegt, deren Einstellschrittweite gleich der durch den Nenner (e) der Teilungszahl (c/e) geteilten Periodendauer (T) des frequenzzuteilenden Signals (F) ist und deren Eingang mit dem Höchstzählerstandausgang (Am) des Zählers (Z) verbunden ist,
- der Überlaufausgang (Ao) des ersten Addierers (A1) an der niederstwertigen Stelle (LB) des ersten Eingangs (E1) eines zweiten Addierers (A2) liegt, dessen zweiter Eingang (E2) an den die ganzzahligen Stellen (a) der die Teilungszahl (c/e) enthaltenden Stufen (Ra) des Teilungszahlregisters (R) angeschlossen ist, und dessen Ausgang (A) an einem Eingang des Zählers (Z) liegt,
gekennzeichnet durch folgende Merkmale:
- der Enable-Eingang (En) des Pufferspeichers (S) ist mit einem der vor dem Höchstzählerstandausgang (Am) liegenden Zählerstandausgänge (An) des Zählers (Z) verbunden,
- der Ausgang (A) des zweiten Addierers (A2) liegt am Einstelleingang (Es) des Zählers (Z),
- der Frequenzteiler ist in integrierter Isolierschicht-Feldeffekttransistor-Technik realisiert,
- Der erste Addierer (A1) und der Pufferspeicher (S) sind pro Stelle der nichtganzen Stellen (b) der Teilungszahl (c/e) zu abwechselnd aufeinanderfolgenden Zellen (z1, z2) erster bzw. zweiter Art zusammengefasst,
- die Zelle (z1) erster Art besteht aus einer Ripple-Carry-Addierstufe mit einem ersten und einem zweiten Komplexgatter (1j, 2j), zwei Invertern (i1, i2) und drei Transistoren (t1, t2, t3), wobei
-- die Schaltstrecken des ersten und des zweiten Transistors (t1, t2) in Serie zwischen dem Ausgang des ersten Komplexgatters (1j) und dem des ersten Inverters (i1) liegen, mit dessen Eingang der Ausgang des zweiten Inverters (i2) verbunden ist,

-- der Eingang des zweiten Inverters (i2) am Verbindungspunkt der Schaltstrecken des ersten und des zweiten Transistors (t1, t2) und sein Ausgang über die Schaltstrecke des dritten Transistors (t3) am zweiten Eingang (e2) der Ripple-Carry-Addierstufe liegt, deren erster Eingang der erste Eingang (E1) des ersten Addierers (A1) ist,

-- das Gate des ersten Transistors (t1) der Enable-Eingang (En) des Pufferspeichers (S) und das Gate des zweiten Transistors (t2) mit diesem über einen allen Zellen (z1, z2) erster und zweiter Art gemeinsamen dritten Inverter (i3) verbunden ist, und

-- der Ausgang des zweiten Inverters (i2) der Ausgang der Zelle (z1) erster Art ist,

- die Zelle (z2) zweiter Art besteht aus denselben Teilschaltungen wie die Zelle (z1) erster Art, die untereinander in derselben Art und Weise verbunden sind, jedoch ist der Ausgang des ersten Inverters (i1) der Ausgang der Zelle (z2) zweiter Art und deren erstem Eingang ist ein vierter Inverter (i4) vorgeschaltet,

- der zweite Addierer (A2) besteht aus abwechselnd aufeinanderfolgenden Stufen (s1, s2) erster und zweiter Art,

- die Stufe (s1) erster Art besteht aus einem NOR-Gatter (5) mit zwei Eingängen, einem fünften Inverter (i5) und einem dritten Komplexgatter (3), wobei

-- der zweite Eingang (E2) des ersten Addierers (A1) der Eingang des fünften Inverters (i5) ist,

-- das dritte Komplexgatter (3) eine UND-Verknüpfung (31) mit zwei Eingängen enthält, deren Ausgang mit dem Übertragsausgang (CI) NOR-verknüpft ist,

-- der Übertrageingang (Ck) am ersten Eingang des NOR-Gatters (5) und am ersten Eingang der UND-Verknüpfung (31) liegt, deren zweiter Eingang zusammen mit dem zweiten Eingang des NOR-Gatters (5) am Ausgang des fünften Inverters (i5) angeschlossen ist, und

-- der Ausgang des dritten Komplexgatters (3) der Ausgang (A) und der Ausgang des NOR-Gatters (5) der Übertragsausgang (CI) der Stufe (s1) erster Art ist, und

- die Stufe (s2) zweiter Art besteht aus einem NAND-Gatter (6) mit zwei Eingängen, einem vierten Komplexgatter (4) und einem sechsten Inverter (i6), wobei

-- das vierte Komplexgatter (4) eine ODER-Verknüpfung (41) mit zwei Eingängen enthält, deren Ausgang mit dem Übertragsausgang (CI) NAND-verknüpft ist,

-- der Übertragseingang (Ck) am ersten Eingang des NAND-Gatters (6) und am ersten Eingang der NOR-Verknüpfung (41) liegt, deren zweiter Eingang zusammen mit dem zweiten Eingang des NAND-Gatters (6) der Eingang der Stufe (s2) zweiter Art ist, und der Ausgang des NAND-Gatters (6) der Übertragsausgang (CI) und der Ausgang des sechsten Inverters (i6) der Ausgang (A) der Stufe (s2) zweiter Art ist.

2. Verwendung eines Frequenzteilers nach Anspruch 1 in digitalen Frequenz/Phasenregelschleifen.

3. Verwendung nach Anspruch 2 in mit digitaler Signalaufbereitung arbeitenden Fernsehempfängern.

## Claims

1. Frequency divider presettable to fractional divisors (c/e) which includes a counter (Z) presettable to integers, and wherein

- those stages (Rb) of a divisor register (R) which hold the fractional parts (b) of the divisor (c/e) in decimal point representation (a + 0.b) are connected to the first input (E1) of a first adder (A1) having its output (A) coupled to the input of a buffer memory (S),
- the output of the buffer memory (S) is coupled to the second input (E2) of the first adder (A1) and to the set input (Es) of a digitally adjustable delay line (V) whose setting-step width is equal to the period (T) of the divider's input signal (F) divided by the denominator (e) of the divisor (c/e), and whose input is connected to the maximum-count output (Am) of the counter (Z), and
- the overflow output (Ao) of the first adder (A1) is coupled to the least-significant-digit terminal (LB) of the first input (E1) of a second adder (A2), whose second input (E2) is connected to those stages (Ra) of the divisor register (R) holding the integral parts (a) of the divisor (c/e), and whose output (A) is coupled to an input of the counter (Z), characterized by the following features:
- the enable input (En) of the buffer memory (S) is connected to one of the count outputs (An) of the counter (Z) which lie before the maximum-count output (Am);
- the output (A) of the second adder (A2) is connected to the set input (Es) of the counter (Z);
- the frequency divider is implemented using insulated-gate field-effect transistor technology (MOS technology);
- for each digit of the fractional parts (b) of the divisor (c/e), the first adder (A1) and the buffer memory /S) are combined in cells of a first kind (z1) and cells of a second kind (z2) which succeed each other by turns;
- the cell (z1) of the first kind is a ripple-carry adder stage comprising a first complex logic-circuit block (1j), a second complex logic-circuit block (2j), two inverters (i1, i2), and three transistors (t1, t2, t3), with

-- the controlled current paths of the first and second transistors (t1, t2) connected in series between the output of the first complex logic-circuit block (1i) and the output of the first inverter (i1), which has its input connected to the output of the second inverter (i2),

-- the input of the second inverter (i2) connected to the node of the controlled current paths of the first and second transistors (t1, t2), ad the output of the second inverter (i2) connected via the controlled current path of the third transistor (t3) to the second input (E2) of the ripple-carry adder stage, whose first input is the first input (E1) of the first adder (A1),

-- the gate of the first transistor (t1) being the enable input (En) of the buffer memory (S), and the gate of the second transistor (t2) connected to this enable input (En) via a third inverter (i3), which is common to all cells (z1, z2) of the first kind and the second kind, and

-- the output of the second inverter (i2) being the output of the cell (z1) of the first kind;

- the cell (z2) of of the second kind consists of the same subcircuits as the cell (z1) of the first kind which are interconnected in the same manner, but the output of the first inverter (i1) is the output of the cell (z2) of the second kind, and the first input of this cell (z2) is preceded by a fourth inverter (i4),

- the second adder (A2) consists of stages of a first kind (s1) and of stages of a second kind (s2) which succeed each other by turns,

- the stage (s1) of the first kind consists of a two-input NOR block (5), a fifth inverter (i5), and a third complex logic-circuit block (3), with

-- the second input (E2) of the first adder (A1) being the input of the fifth inverter (i5),

-- the third complex logic-circuit block (3) containing a two-input AND gate (31) whose output is NORed with the carry output (Cl),

-- the carry input (Ck) connected to the first input of the NOR block (5) and to the first input of the AND gate (31), whose second input, together with the second input of the NOR block (5), is connected to the output of the fifth inverter (i5), and

-- the output of the third complex logic-circuit block (3) being the output (A) of the stage (s1) of the first kind, and the output of the NOR block (5) being the carry output (Cl) of this stage (s1), and

- the stage (s2) of the second kind consisting of a two-input NAND block (6), a fourth complex logic-circuit block (4), and a sixth inverter (i6), whith

-- the fourth complex logic-circuit block (4) containing a two-input OR gate (41) whose output is NANDed with the carry output (Cl),

-- the carry input (Ck) connected to the first input of the NAND block (6) and to the first input of the NOR gate (41), whose second input, together with the second input of the NAND block (6), is the input of the stage (s2) of the second kind, and

-- the output of the NAND block (6) being the carry output (Cl) of the stage (S2) of the second kind, and the output of the sixth inverter (i6) being the output (A) of this stage (s2).

2. Use of a frequency divider as claimed in claim 1 in digital phase-locked loops.

3. Use as claimed in claim 2 in television receivers employing digital signal processing techniques.

**Revendications**

1. Diviseur de fréquence réglable sur des diviseurs non entiers (c/e), comportant un compteur réglable sur des nombres entiers (Z), dans lequel

- les étages (Rb) d'un registre de diviseur (R), renfermant les chiffres non entiers (b) du diviseur (c/e) en notation avec virgule (a + 0,b) sont raccordés à la première entrée (E1) d'un premier additionneur (A1) dont la sortie (A) est reliée à l'entrée d'une mémoire tampon (S),

- la sortie de la mémoire tampon (S) est reliée d'une part à la seconde entrée (E2) du premier additionneur (A1) et d'autre part à l'entrée de réglage (Es) d'une ligne à retard réglable numériquement (V) dont l'amplitude du pas de retard est égale à la période (T) du signal à diviser en fréquence (F) divisée par le dénominateur (e) du diviseur (c/e) et dont l'entrée est raccordée à la sortie de position de comptage maximum (Am) du compteur (Z),

- la sortie de dépassement (Ao) du premier additionneur (A1) est reliée au chiffre le moins significatif (LB) de la première entrée (E1) d'un second additionneur (A2) dont la seconde entrée (E2) est raccordée aux étages (Ra) du registre de diviseurs (R) renfermant les chiffres entiers (a) du diviseur (c/e) et dont la sortie (A) est reliée à une entrée du compteur (Z), caractérisé en ce que

- l'entrée de validation (En) de la mémoire tampon (S) est raccordée à l'une des sorties de position de comptage (An) du compteur (Z) placés avant la sortie de position de comptage maximum (Am),

- la sortie (A) du second additionneur (A2) est reliée à l'entrée de réglage (Es) du compteur (Z),

- le diviseur de fréquence est réalisé en technique intégrée à transistors à effet de champ à grille isolée,

- le premier additionneur (A1) et la mémoire tampon (S) sont regroupés, pour chacun des chiffres non entiers (b) du nombre de division (c/e), en cellules successives alternées (z1, z2) du premier ou, suivant le cas, du second type,

- la cellule (z1) du premier type se compose d'un étage additionneur à report simultané comportant un premier et un seconde circuit complexe (1j, 2j), deux inverseurs (i1, i2) et trois transistors (t1, t2, t3), dans laquelle

-- les trajets de connexion du premier et du second transistors (t1, t2) sont reliés en série entre la sortie du premier circuit complexe (1j) et celle du premier inverseur (i1) avec l'entrée duquel est raccordée la sortie du second inverseur (i2),

-- l'entrée du second inverseur (i2) est reliée au point de jonction des trajets de connexion du premier et du second transistor (t1, t2) et sa sortie est reliée, par l'intermédiaire du trajet de connexion du troisième transistor (t3), à la seconde entrée (e2) de l'étage additionneur à réport simultané dont la première entrée est la première entrée (E1) du premier additionneur (A1),

-- la grille du premier transistors (t1) est l'entrée de validation (En) de la mémoire tampon (S) et la grille du second transistors (t2) est raccordée à cette dernière par l'intermédiaire d'un troisième inverseur (13) commun à toutes les cellules (z1, z2) du premier et du second type, et

-- la sortie du second inverseur (i2) est la sortie de la cellule (z1) du premier type,

- la cellule (z2) du second type se compose des mêmes sous-circuits que la cellule (z1) du premier type, lesdits sous-circuits étant raccordés ensemble de la même manière, mais la sortie du premier inverseur (i1) est la sortie de la cellule (z2) du second type et un quatrième inverseur (i4) est placé en amont de sa première entrée,
- le second additionneur (A2) se compose d'étages successifs alternés (s1, s2) du premier et du second type,
- l'étage (s1) du premier type se compose d'un circuit OU-NON (5) comportant deux entrées, un cinquième inverseur (i5) et un troisième circuit complexe (3), pour lesquels
-- la seconde entrée (E2) du premier additionneur (A1) est l'entrée du cinquième inverseur (i5),
-- le troisième circuit complexe (3) renferme une porte ET (31) à deux entrées dont la sortie est raccordée par une porte OU-NON à la sortie de report (CI),
-- l'entrée de report (Ck) est reliée à la première entrée du circuit OU-NON (5) et à la première entrée de la porte ET (31) dont la seconde entrée est raccordée, avec la seconde entrée du circuit OU-NON (5), à la sortie du cinquième inverseur (i5), et

-- la sortie du troisième circuit complexe (3) est la sortie (A) et la sortie du circuit OU-NON (5) la sortie de report (CI) de l'étage (s1) du premier type, et
- l'étage (s2) du second type se compose d'un circuit ET-NON (6) comportant deux entrées, un quatrième circuit complexe (4) et un sixième inverseur (i6), pour lesquels
-- le quatrième circuit complexe (4) renferme une porte OU (41) à deux entrées dont la sortie est raccordée par une porte ET-NON à la sortie de report (CI),
-- l'entrée de report (Ck) est réliée à la première entrée du circuit ET-NON (6) et à la première entrée de la porte OU-NON (41) dont la seconde entrée est, avec la seconde entrée du circuit ET-NON (6), l'entrée de l'étage (s2) du second type, la sortie du circuit ET-NON (6) étant la sortie de report (CI) et la sortie du sixième inverseur (i6) étant la sortie (A) de l'étage (s2) du second type.

2. Application d'un diviseur de fréquence conforme à la revendication 1, aux boucles numériques de réglage phase/fréquence.

3. Application conforme à la revendication 2, aux récepteurs de télévision fonctionnant avec un dispositif de mise en forme numérique du signal.

$$a + 0, b = \frac{c}{e} = a + \frac{d}{e}$$

FIG. 1

$$T' = T\,\frac{ae + 1}{e}$$

FIG. 3

0 < j = i + 1 < n-1

0 < i = j-1 < n-1

FIG.4

FIG.5

E1(A1)

z1

Ci

E2 (A1)

$\overline{C}j$

Es(V)

i2    i1

2j    1j    t1    t2    i3

En

**FIG. 6a**

E1 (A1)  i4

z2

$\overline{C}$

E2 (A1)

Ci

i2    i1

2i    1i    t1    t2    i3

Es(V)

En

**FIG. 6b**

s1

E2(A1)

**FIG. 7a**

i5

Ck    31    Cl

3

5    32

A(S)

s2

E2 (A1)

**FIG. 7b**

Ck    41    Cl

l = k + 1    4

6    42    i6

A(S)

FIG. 8